# EUROPEAN PATENT APPLICATION

(11) **EP 4 625 603 A1**
(43) Date of publication of application: **01.10.2025**
(21) Application number: 25153783.3
(22) Date of filing: 24.01.2025
(51) Int. Cl.: H01M 10/42, H01M 10/48, H01M 50/209, H01M 50/213, H01M 50/284, H01M 50/502, H01M 50/505, H01M 50/569, H01R 12/51, H01R 12/53, H01R 12/58, H01R 4/02

(54) **SIGNAL ACQUISITION ASSEMBLY OF CELL AND BATTERY PACK**

(30) Priority: 29.03.2024 CN 202420650160 U; 19.07.2024 WO PCT/CN2024/106318
(71) Applicant: Eve Energy Co. Ltd., Huizhou, Guangdong 516000 (CN)
(72) Inventor: LIANG, Xianyu, Huizhou, 516006 (CN); WEI, Xueqing, Huizhou, 516006 (CN); LIU, Pingping, Huizhou, 516006 (CN)
(74) Representative: Tiburzi, Andrea

(57) **Abstract**

Provided are a signal acquisition assembly (1) of a cell (20) and a battery pack. The signal acquisition assembly (1) includes a support, a circuit board (11), multiple pin-type electrical connectors (12), and multiple signal acquisition lines (13). The support (1) includes a first side surface (101) and a second side surface (102) opposite to each other in a first direction. The circuit board (11) is provided with multiple plug-in structures (110). A pin-type electrical connector (12) has a first connection portion (1210) and a pin-type plug-in portion (1220). Pin-type plug-in portions (1220) of the pin-type electrical connectors (12) are plugged in the plug-in structures in one-to-one correspondence. The pin-type plug-in portion (1220) is electrically connected to a battery management circuit (113) carried by the circuit board (11). Second connection portions (130) of the signal acquisition lines (13) are correspondingly connected to first connection portions (1210) of the multiple pin-type electrical connectors (12). The acquisition portion (131) of the signal acquisition line (13) is configured to acquire the signal of the cell (20).

## Description

### TECHNICAL FIELD

The present application relates to the field of battery technology and, in particular, a signal acquisition assembly of a cell and a battery pack.

### BACKGROUND

In a battery pack, to monitor the usage of cells, an acquisition harness is often used to acquire and transmit signals of the cells, for example, the voltage signal and temperature signal of the cells. In the related art, a harness connector is usually used to aggregate acquisition harnesses and is plugged in a circuit connector on a circuit board to connect the acquisition harnesses to a battery management circuit carried by the circuit board.

However, when a battery pack vibrates (for example, during a production and assembly process, during transportation of the battery pack, and during the driving of a vehicle equipped with the battery pack), the harness connector and the circuit connector are prone to looseness and poor contact.

### SUMMARY

In a first aspect, the present application provides a signal acquisition assembly of a cell.

The signal acquisition assembly includes a support, a circuit board, multiple pin-type electrical connectors, and multiple signal acquisition lines.

The support includes a first side surface and a second side surface opposite to each other in a first direction. The first side surface is configured to mount the cell.

The circuit board is connected to the support and located on the second side surface. The circuit board is provided with multiple plug-in structures. The circuit board carries a battery management circuit. The battery management circuit is configured to be electrically connected to the cell.

Each pin-type electrical connector has a first connection portion and a pin-type plug-in portion. Pin-type plug-in portions of the multiple pin-type electrical connectors are plugged in the multiple plug-in structures in one-to-one correspondence. The pin-type plug-in portion is electrically connected to the battery management circuit.

Each signal acquisition line has a second connection portion and an acquisition portion. Second connection portions of the multiple signal acquisition lines are correspondingly connected to first connection portions of the multiple pin-type electrical connectors. The acquisition portion is configured to acquire a signal of the cell.

In one or more embodiments, the support also includes a limit structure protruding from the second side surface. The multiple pin-type electrical connectors are partially disposed in the limit structure, and at least part of the first connection portion and the pin-type plug-in portion are exposed to the external environment of the support.

In one or more embodiments, a side of the circuit board facing the second side surface carries multiple electronic components. In the first direction, the projections of the multiple electronic components and the projection of the limit structure on the circuit board do not overlap.

In the first direction, the height of the limit structure protruding from the second side surface is h1, and the maximum height of the multiple electronic components protruding from the circuit board in the first direction toward the support is h2, and h1 ≥ h2.

In one or more embodiments, the pin-type electrical connector includes a first portion and a second portion connected at an included angle. The first portion has the first connection portion and is disposed in the support. The second portion has the pin-type plug-in portion.

In one or more embodiments, the second side surface is formed with multiple first limit grooves arranged at intervals. A first limit groove is provided with a first opening facing the circuit board. The first portion is at least partially disposed in a respective first limit groove. A side of the first connection portion away from the bottom of the first limit groove is at least partially exposed to the external environment of the support through the first opening.

In one or more embodiments, the second portion includes a main body portion connected between the first portion and the pin-type plug-in portion. The support also includes a second limit portion disposed on the second side surface. The second limit portion is formed with multiple second limit grooves arranged at intervals. A second limit groove is provided with a second opening located on a side of the second limit portion adjacent to the circuit board. The main body portion is disposed in a respective second limit groove. The pin-type plug-in portion at least partially extends from the second opening toward the circuit board.

In one or more embodiments, the multiple pin-type electrical connectors are embedded in the support.

In one or more embodiments, the first connection portion is located between the support and the circuit board.

In one or more embodiments, the pin-type plug-in portion is also welded to the circuit board and electrically connected to the battery management circuit. Alternatively, a plug-in structure also includes an elastic conductive member. The elastic conductive member is electrically connected to the battery management circuit and configured to elastically abut against the pin-type plug-in portion.

In one or more embodiments, the multiple signal acquisition lines include a first acquisition line. The acquisition portion of the first acquisition line is connected to a temperature sensing member.

The support is provided with a first accommodation recess formed in the first side surface. The first accommodation recess is configured to accommodate the cell. The support is also provided with a second accommodation recess communicating with the first accommodation recess. The temperature sensing member is disposed in the second accommodation recess.

In one or more embodiments, the support is provided with the first accommodation recess formed in the first side surface. The first accommodation recess is configured to accommodate the cell. The support is provided with multiple first accommodation recesses. The multiple first accommodation recesses are arranged in a second direction. Each first accommodation recess is configured to accommodate a cell. The signal acquisition assembly also includes an electrical connection piece. The electrical connection piece corresponds to a side of any two adjacent first accommodation recesses in a third direction and is disposed on the support. The electrical connection piece is configured to electrically connect two cells located in the two adjacent first accommodation recesses. The first direction, the second direction, and the third direction intersect each other in pairs.

The multiple signal acquisition lines include a second acquisition line. The acquisition portion of the second acquisition line is connected to and electrically conducted with the electrical connection piece.

In one or more embodiments, the electrical connection piece is formed with an engaging hole, and the support is provided with a protrusion corresponding to the engaging hole. Alternatively, the support is formed with an engaging hole, and the electrical connection piece is provided with a protrusion corresponding to the engaging hole. The protrusion is configured to pass through the engaging hole to enable the electrical connection piece to be engaged with the support.

In one or more embodiments, the signal acquisition assembly also includes a busbar. The busbar has a first end and a second end opposite to each other. The first end is configured to be electrically connected to the cell. The second end is configured to be electrically connected to the battery management circuit. The support is provided with a first threaded hole. The circuit board is provided with a first through hole corresponding to the first threaded hole. The second end is provided with a second through hole corresponding to the first through hole. A first bolt passes through the second through hole and the first through hole in sequence and is screwed into the first threaded hole to connect the second end and the circuit board to the support.

In one or more embodiments, the busbar also includes an arched bending structure connected between the first end and the second end, and the arched bending structure is configured to be elastically deformed.

In a second aspect, a battery pack is provided. The battery pack includes a cell and the signal acquisition assembly as described in the first aspect. The cell is mounted on the first side surface.

The present application has beneficial effects described below.

The circuit board is connected to the side of the support in the first direction, and the support is directly provided with multiple pin-type electrical connectors so that the pin-type plug-in portion of the pin-type electrical connector can be directly plugged in the plug-in structure of the circuit board and the circuit board can be connected to the support. In this manner, the pin-type plug-in portion and the plug-in structure maintain a stable plug-in relationship; thus, when the battery pack vibrates, the pin-type plug-in portion and the plug-in structure can still maintain a relatively stable and effective plug-in relationship and are not prone to problems such as looseness and poor contact. Thus, the functional stability of the battery pack is better.

### BRIEF DESCRIPTION OF THE DRAWINGS

The present application is further described below in detail in conjunction with drawings and embodiments.
FIG. 1 is a perspective view of a signal acquisition assembly of a cell at an angle according to an embodiment of the present application.
FIG. 2 is a perspective view of a signal acquisition assembly of a cell at another angle according to an embodiment of the present application.
FIG. 3 is a top view of a signal acquisition assembly of a cell according to an embodiment of the present application.
FIG. 4 is an exploded view of the structure of the signal acquisition assembly of a cell shown in FIG. 2.
FIG. 5 is a perspective view of a pin-type electrical connector, a signal acquisition line, and a temperature sensing member shown in FIG. 4.
FIG. 6 is a sectional view taken along direction A-A of FIG. 3.
FIG. 7 is a sectional view taken along direction B-B of FIG. 3.
FIG. 8 is a perspective view of a battery pack according to an embodiment of the present application.

### Reference list

- 1: signal acquisition assembly
- 10: support
- 101: first side surface
- 102: second side surface
- 102a: first bolt
- 102b: second bolt
- 103: first accommodation recess
- 104: limit structure
- 1041: first limit groove
- 1041a: first opening
- 1042: second limit portion
- 1042a: second limit groove
- 1042b: second opening
- 1043: first limit portion
- 105: second accommodation recess
- 106: protrusion
- 11: circuit board
- 110: plug-in structure
- 111: electronic component
- 12: pin-type electrical connector
- 121: first portion
- 1210: first connection portion
- 122: second portion
- 1220: pin-type plug-in portion
- 1221: main body portion
- 13: signal acquisition line
- 130: second connection portion
- 131: acquisition portion
- 13a: first acquisition line
- 13b: second acquisition line
- 14: busbar
- 141: first end
- 142: second end
- 143: arched bending structure
- 15: electrical connection piece
- 150: engaging hole
- 16: temperature sensing member
- 2: battery pack
- 20: cell

### DETAILED DESCRIPTION

In the description of the present application, unless otherwise expressly specified and limited, the term "connected to each other", "connected" or "secured" is to be construed in a broad sense, for example, as securely connected, detachably connected or integrated; mechanically connected or electrically connected; directly connected to each other or indirectly connected to each other via an intermediary; or internally connected between two elements or interaction relations between two elements. For those of ordinary skill in the art, specific meanings of the preceding terms in the present application may be understood based on specific situations.

In the present application, unless otherwise expressly specified and limited, when a first feature is described as "on" or "below" a second feature, the first feature and the second feature may be in direct contact, or be in contact via another feature between the two features instead of being in direct contact. Moreover, when the first feature is described as "on", "above" or "over" the second feature, the first feature is right on, above or over the second feature, or the first feature is obliquely on, above or over the second feature, or the first feature is simply at a higher level than the second feature. When the first feature is described as "under", "below" or "underneath" the second feature, the first feature is right under, below or underneath the second feature, or the first feature is obliquely under, below or underneath the second feature, or the first feature is simply at a lower level than the second feature.

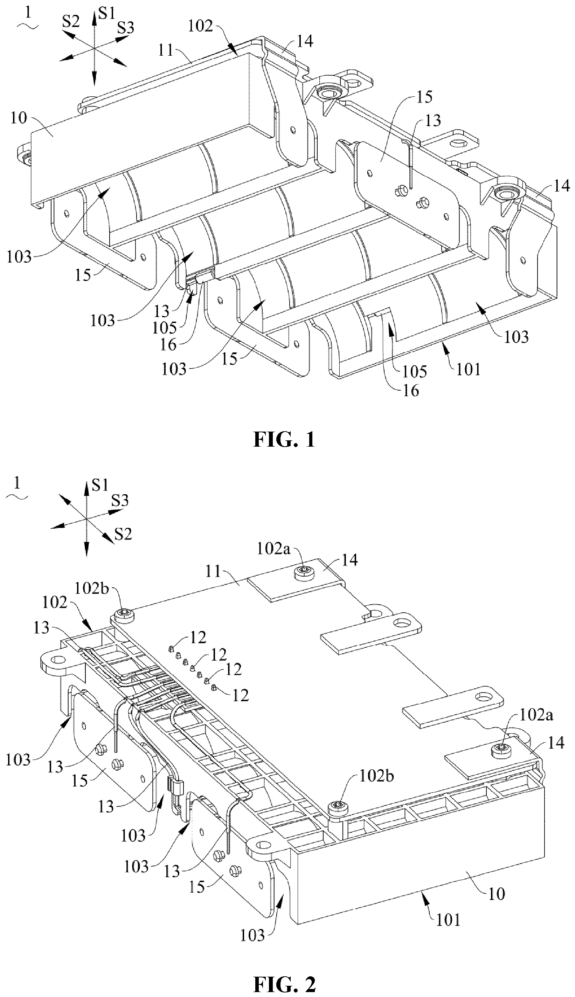

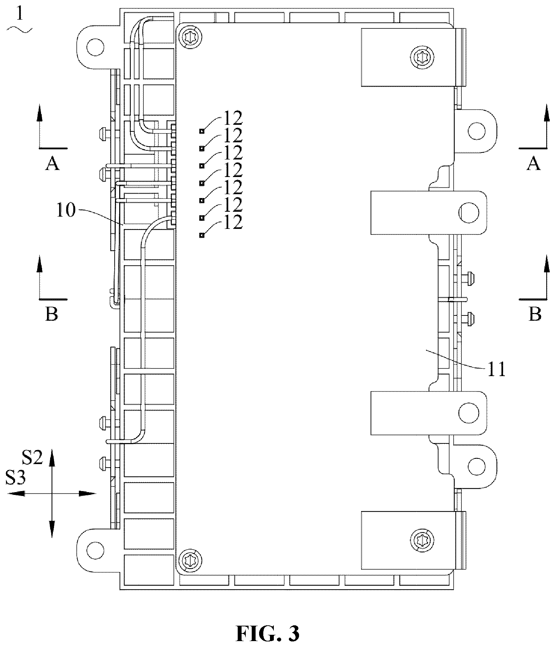

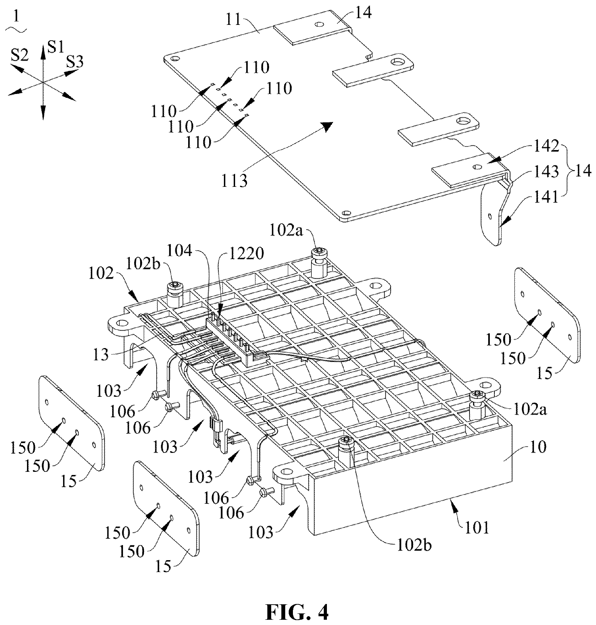

As shown in FIGS. 1 to 5, the present application provides a signal acquisition assembly 1 of a cell. The signal acquisition assembly 1 includes a support 10, a circuit board 11, multiple pin-type electrical connectors 12, and multiple signal acquisition lines 13. The support 10 includes a first side surface 101 and a second side surface 102 opposite to each other in a first direction S1. The first side surface 101 is configured to mount the cell. The circuit board 11 is connected to the support 10 and located on the second side surface 102. The circuit board 11 is provided with multiple plug-in structures 110. The circuit board 11 carries a battery management circuit. The battery management circuit is configured to be electrically connected to the cell. A pin-type electrical connector 12 has a first connection portion 1210 and a pin-type plug-in portion 1220. Multiple first connection portions 1210 are arranged at intervals on the support 10. The pin-type plug-in portions 1220 of multiple pin-type electrical connectors 12 are plugged in the plug-in structures 110 in one-to-one correspondence. The pin-type plug-in portion 1220 is electrically connected to the battery management circuit. A signal acquisition line 13 has a second connection portion 130 and an acquisition portion 131. Second connection portions 130 of multiple signal acquisition lines 13 are correspondingly connected to first connection portions 1210 of the multiple pin-type electrical connectors 12. The acquisition portion 131 is configured to acquire the signal of the cell. The first direction S1 is indicated by arrows in FIGS. 1, 2, 4, and 5.

The circuit board 11 is connected to a side of the support 10 in the first direction S1, and the support 10 is directly provided with multiple pin-type electrical connectors 12 so that the pin-type plug-in portion 1220 of the pin-type electrical connector 12 can be directly plugged in the plug-in structure 110 of the circuit board 11. The circuit board 11 is connected to the support 10 so that the pin-type plug-in portion 1220 and the plug-in structure 110 maintain a stable plug-in relationship; thus, when the battery pack vibrates, the pin-type plug-in portion 1220 and the plug-in structure 110 can still maintain a relatively stable and effective plug-in relationship and are not prone to problems such as looseness and poor contact. Thus, the functional stability of the battery pack is better.

It is to be understood that the circuit board 11 may include a battery management system (BMS), and the battery management circuit may be a circuit included in the battery management system.

In one or more embodiments, the signal acquisition assembly 1 also includes two busbars 14. A busbar 14 has a first end 141 and a second end 142 opposite to each other. The first end 141 is configured to be electrically connected to the output electrode of an output cell among multiple cells connected in series or in parallel. The second end 142 is electrically connected to the battery management circuit 113. Thus, the cells carried by the support 10 can be connected to the battery management circuit 113 as a whole through the two busbars 14.

In one or more embodiments, the support 10 is formed with a first threaded hole. The circuit board 11 is formed with a first through hole corresponding to the first threaded hole. The second end 142 is formed with a second through hole corresponding to the first through hole. A first bolt 102a passes through the second through hole and the first through hole in sequence and is screwed into the first threaded hole so that the second end 142 and the circuit board 11 are connected to the support 10. The first bolt 102a is screwed into the first threaded hole so that the second end 142, the circuit board 11, and the support 10 can be connected and limited in position.

In one or more embodiments, the busbar 14 also includes an arched bending structure 143 connected between the first end 141 and the second end 142, and the arched bending structure 143 is configured to be elastically deformed. In this manner, the relative position between the first end 141 and the second end 142 can be changed to a certain extent so that the first end 141 is correspondingly connected to the cell carried by the support 10. In one or more embodiments, in a case where the second end 142 is connected to the support 10 by the first bolt 102a, since the relative position of the second end 142 and the support 10 is relatively fixed, the relative position between the first end 141 and the support 10 can be changed to a certain extent through elastic deformation of the arched bending structure 143, which plays a buffering role. Thus, it facilitates the corresponding connection between the first end 141 and the cell 20 carried by the support 10.

In one or more embodiments, the support 10 is also formed with a second threaded hole. The circuit board 11 is also formed with a third through hole corresponding to the second threaded hole. A second bolt 102b passes through the third through hole and is screwed into the second threaded hole to connect the circuit board 11 to the support 10. In this manner, the second bolt 102b is screwed into the second threaded hole so that the circuit board 11 and the support 10 can be connected and limited in position. Further, the position where the circuit board 11 and the support 10 are connected and limited can be increased to further improve the stability of the relative position of the circuit board 11 and the support 10 after the circuit board 11 is assembled on the support 10. Thus, the stability of the plug-in relationship between the pin-type plug-in portion 1220 and the plug-in structure 110 is further improved.

In one or more embodiments, the support 10 has a first accommodation recess 103 formed in the first side surface 101. The first accommodation recess 103 is configured to accommodate the cell.

In one or more embodiments, the support 10 has multiple first accommodation recesses 103. The multiple first accommodation recesses 103 are arranged in a second direction S2. Each first accommodation recess 103 is configured to accommodate one cell. Thus, the support 10 can be configured to accommodate multiple cells. The second direction S2 intersects the first direction S1. The second direction S2arrows in FIG. 1 to FIG. 5.

Further, the signal acquisition assembly 1 also includes an electrical connection piece 15. The electrical connection piece 15 may be a copper bar or an aluminum bar. The electrical connection piece 15 is disposed on the support 10 and corresponds to a side of any two adjacent first accommodation recesses 103 in a third direction S3. The electrical connection piece 15 is configured to electrically connect two cells located in two adjacent first accommodation recesses 103 respectively. The electrical connection piece 15 connects the multiple cells carried by the support 10 in series or in parallel or connects part of the multiple cells in series and part of the cells in parallel. The first direction S1, the second direction S2, and the third direction S3 intersect each other in pairs. The third direction S3 is indicated by arrows in FIG. 1 to FIG. 5. The coordinates in FIG. 1, FIG. 2, FIG. 4, and FIG. 5 indicate the first direction S1, the second direction S2, and the third direction S3. For example, the first direction S1, the second direction S2, and the third direction S3 may be perpendicular to each other in pairs.

In one or more embodiments, one of the electrical connection piece 15 or the support 10 is formed with an engaging hole 150, and the other one is provided with a protrusion 106 corresponding to the engaging hole 150, that is, the electrical connection piece 15 may be formed with an engaging hole 150, and the support 10 is provided with a protrusion 106 corresponding to the engaging hole 150. Alternatively, the support 10 may be formed with an engaging hole 150, and the electrical connection piece 15 is provided with a protrusion 106 corresponding to the engaging hole 150. The protrusion 106 is capable of passing through the engaging hole 150 to enable the electrical connection piece 15 to be engaged with the support 10. Thus, during the assembly process of the signal acquisition assembly 1, the relative position of the electrical connection piece 15 and the support 10 is relatively fixed so that the signal acquisition assembly 1 can be assembled into an integral structure.

In one or more embodiments, the protrusion 106 may be a hot rivet pin. For example, the protrusion 106 may be made of a plastic material that can melt at a high temperature. After the protrusion 106 correspondingly passes through the engaging hole 150, hot pressing may be performed on an end of the protrusion 106, so that the protrusion 106 is riveted to the electrical connection piece 15, and the electrical connection piece 15 and the support 10 are further fixed.

In one or more embodiments, the plug-in structure 110 may include a plug-in hole or a plug-in groove so that the pin-type plug-in portion 1220 can be plugged in the plug-in structure 110 by plugging in the plug-in hole or the plug-in groove. A pin-type electrical connector 12 may be a pin. In addition, since the disposition space and mounting space occupied by the structure of the pin and the plug hole or the plug groove are smaller than that of a male-female plug structure such as a harness connector and a circuit connector in the related art, the cooperation structure between the pin-type plug-in portion 1220 and the plug-in structure 110 can make the overall structure of the signal acquisition assembly 1 more compact. Thus, it is beneficial to further improve the energy density of the battery pack including the signal acquisition assembly 1.

To easily maintain the stable electrical connection between the pin-type plug-in portion 1220 and the battery management circuit so that the signal acquisition function of the signal acquisition assembly 1 can be more stable, in one or more embodiments, the pin-type plug-in portion 1220 is also welded to the circuit board 11. The pin-type plug-in portion 1220 is electrically connected to the battery management circuit 113 through solder. The solder surrounds the end surface of the plug-in structure 110 and extends into the gap between the plug-in structure 110 and the pin-type plug-in portion 1220. Alternatively, the plug-in structure 110 also includes an elastic conductive member. The elasticity conductive member may include but is not limited to a conductive spring contact and a conductive spring, and the elastic conductive member is electrically connected to the battery management circuit 113 and is capable of elastically abutting against the pin-type plug-in portion 1220. Thus, when the pin-type plug-in portion 1220 is plugged in the plug-in hole, the pin-type plug-in portion 1220 is electrically connected to the battery management circuit 113 through the elastic conductive member.

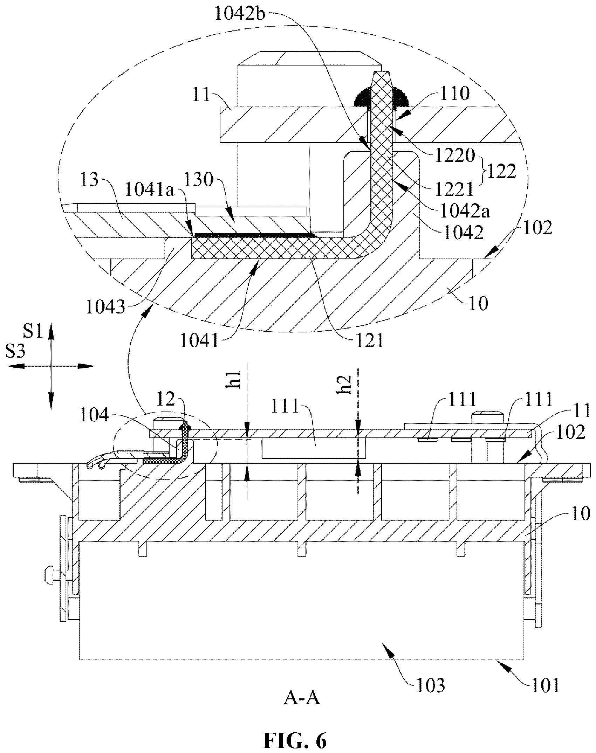

Referring to FIG. 6, in one or more embodiments, the pin-type electrical connector 12 includes a first portion 121 and a second portion 122 connected at an included angle. The first portion 121 has the first connection portion 1210 and is disposed in the support 10. The second portion 122 has the pin-type plug-in portion 1220. In one aspect, the effective connection area between the first portion 121 and the second side surface 102 of the support 10 can be larger so that the connection relationship between the pin-type electrical connector 12 and the support 10 is more stable. In another aspect, the second portion 122 can be bent relative to the first portion 121 toward the circuit board 11, so that the pin-type plug-in portion 1220 can extend away from the support 10 in the first direction S1, and the pin-type plug-in portion 1220 can be plugged in the plug-in structure 110.

In one or more embodiments, the second portion 122 may be a laminar structure so that the surface area of the second portion 122 is larger. In one aspect, the effective connection area between the second portion 122 and the support 10 can be further increased so that the connection stability between the pin-type electrical connector 12 and the support 10 is further improved. In another aspect, the outer surface area of the first connection portion 1210 can be larger, and a larger effective connection area can be provided for the second connection portion 130 so that the first connection portion 1210 and the second connection portion 130 can be more reliably connected.

In one or more embodiments, the first connection portion 1210 may be located between the support 10 and the circuit board 11. In other words, in the first direction S1, the projection of the first connection portion 1210 on the second side surface 102 is located within the projection range of the circuit board 11 on the second side surface 102, so that the pin-type plug-in portion 1220 of the pin-type electrical connector 12 can be directly plugged in the plug-in structure 110 of the circuit board 11 in the first direction S 1. In this manner, in one aspect, the support 10 and the circuit board 11 can shield the first connection portion 1210 from two opposite sides of the first connection portion 1210 in the first direction S1, so that the connection structure of the first connection portion 1210 and the second connection portion 130 can be protected to a certain extent, and the first connection portion 1210 and the second connection portion 130 can maintain a stable connection relationship more easily. In another aspect, the compactness of the first connection portion 1210, the support 10, and the circuit board 11 can also be improved, thereby making the overall structure of the signal acquisition assembly 1 more compact and reasonable.

In other embodiments, in the first direction S1, the projection of the first connection portion 1210 on the second side surface 102 may also be located outside the projection range of the circuit board 11 on the second side surface 102. Alternatively, in the first direction S1, the projection of the first connection portion 1210 on the second side surface 102 may also partially overlap the projection of the circuit board 11 on the second side surface 102.

In one or more embodiments, the multiple pin-type electrical connectors 12 are embedded in the support 10 so that the connection stability between the support 10 and the pin-type electrical connectors 12 can be better.

For example, the entire support 10 may be made of a plastic material, and the support 10 may be injection molded onto the multiple pin-type electrical connectors 12. Thus, the molding process of the support 10 and the process of embedding the multiple pin-type electrical connectors 12 in the support 10 can be completed in one step, and the manufacturing process of the signal acquisition assembly 1 can be simpler.

In one or more embodiments, the support 10 also includes a limit structure 104 protruding from the second side surface 102. The pin-type electrical connectors 12 are partially disposed in the limit structure 104, and at least part of the first connection portion 1210 and the pin-type plug-in portion 1220 are exposed to the external environment of the support 10. Thus, the limit structure 104 is configured to limit the relative position of the pin-type electrical connector 12 and the support 10. At the same time, the limit structure 104 may not affect the connection of the pin-type electrical connector 12 to the second connection portion 130 and the plug-in structure 110, respectively.

In one or more embodiments, the side of the circuit board 11 facing the second side surface 102 carries multiple electronic components 111. In the first direction S1, the projections of the multiple electronic components 111 and the projection of the limit structure 104 on the circuit board 11 do not overlap. In other words, the multiple electronic components 111 and the limit structure 104 located between the circuit board 11 and the second side surface 102 are staggered, so that the disposition compactness of the multiple electronic components 111 and the limit structure 104 can be improved, and the space between the circuit board 11 and the second side surface 102 can be used more effectively. Further, the distance between the circuit board 11 and the second side surface 102 in the first direction S1 can be smaller so that the signal acquisition assembly 1 can be designed to be more compact. Thus, it is beneficial to improve the energy density of the battery pack including the signal acquisition assembly 1 provided in this embodiment.

In the first direction S1, the height of the limit structure 104 protruding from the second side surface 102 is h1, and the maximum height of the multiple electronic components 111 in the first direction S1 is h2. In one or more embodiments, the height h1 and the height h2 may satisfy h1 ≥ h2. Thus, when the pin-type plug-in portion 1220 is plugged in the plug-in structure 110, the circuit board 11 can abut against the protruding top of the limit structure 104, so that the limit structure 104 can better limit and protect the pin-type electrical connector 12.

In one or more embodiments, when the pin-type electrical connector 12 includes a first portion 121 and a second portion 122 connected at an included angle, the second side surface 102 is formed with multiple first limit grooves 1041 arranged at intervals. A first limit groove 1041 has a first opening 1041a facing the circuit board 11. The first portion 121 is at least partially disposed in a respective first limit groove 1041. A side of the first connection portion 1210 away from the bottom of the first limit groove 1041 is at least partially exposed to the external environment of the support 10 through the first opening 1041a. Thus, the first limit groove 1041 is configured to limit the relative position of the first portion 121 and the support 10 so that it is easier to maintain a stable relative position of the entire pin-type electrical connector 12 and the support 10. At the same time, the first connection portion 1210 is exposed through the first opening 1041a so that the first connection portion 1210 can be connected to the second connection portion 130 of a signal acquisition line 13 that is wired outside of the support 10.

In one or more embodiments, the first limit groove 1041 may be directly disposed in the second side surface 102. Alternatively, the support 10 also includes a first limit portion 1043 disposed on the second side surface 102 (that is, the limit structure 104 may include the first limit portion 1043). The first limit portion 1043 is formed with multiple first limit grooves 1041 arranged at intervals.

In one or more embodiments, the second portion 122 includes a main body portion 1221 connected between the first portion 121 and the pin-type plug-in portion 1220. The support 10 also includes a second limit portion 1042 disposed on the second side surface 102 (that is, the limit structure 104 may include the second limit portion 1042). The second limit portion 1042 is formed with multiple second limit grooves 1042a arranged at intervals. A second limit groove 1042a has a second opening 1042b located on a side of the second limit portion 1042 adjacent to the circuit board 11. The main body portion 1221 is disposed in a respective second limit groove 1042a. The pin-type plug-in portion 1220 at least partially extends from the second opening 1042b toward the circuit board 11. Thus, the second limit portion 1042 can limit the relative position of the main body portion 1221 and the support 10 so that it is easier to maintain a stable relative position of the entire pin-type electrical connector 12 and the support 10. At the same time, the pin-type plug-in portion 1220 extends through the second opening 1042b to be plugged in the plug-in structure 110 on the circuit board 11 in the first direction S 1.

In one or more embodiments, the second side surface 102 of the support 10 may be provided with the first limit portion 1043 in the preceding technical solution and the second limit portion 1042 in the preceding technical solution (that is, the limit structure 104 may include the first limit portion 1043 in the preceding technical solution and the second limit portion 1042 in the preceding technical solution). At this time, the first limit groove 1041 communicates with the second limit groove 1042a so that the first portion 121 and the main body portion 1221 can be connected. With this disposition, the positions where the limit structure 104 limits the pin-type electrical connector 12 can be more widely distributed so that the limit structure 104 can better limit the pin-type electrical connector 12, and the relative position stability of the entire pin-type electrical connector 12 and the support 10 is better.

It is to be understood that to monitor the usage of a cell, it is usually necessary to acquire the temperature signal and/or voltage signal of the cell.

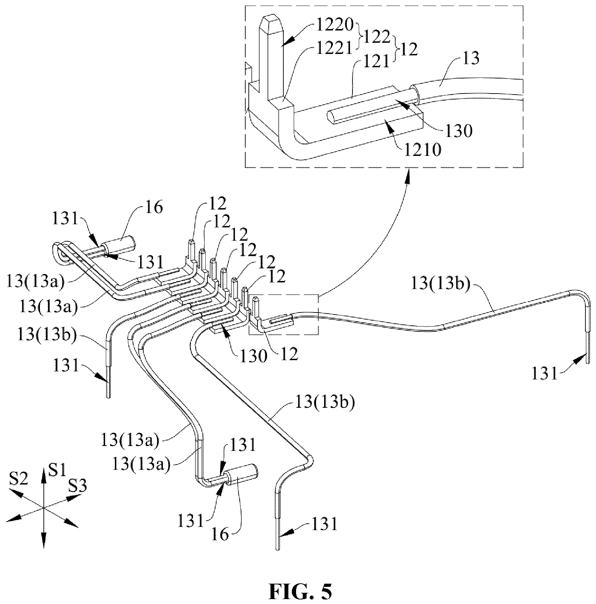

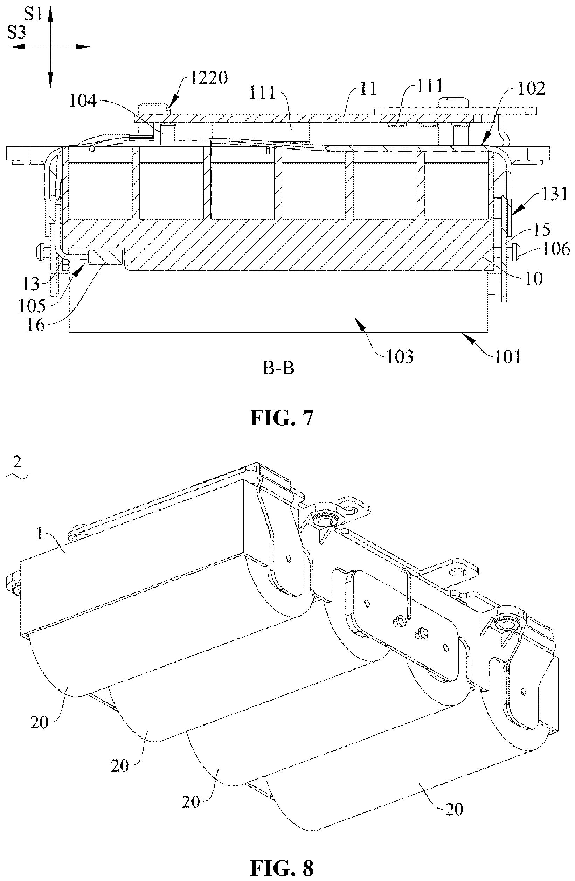

Referring to FIG. 5 and FIG. 7, based on this, when the signal acquisition assembly 1 may be configured to acquire the temperature signal of the cell, in one or more embodiments, the multiple signal acquisition lines 13 include a first acquisition line 13a. The acquisition portion 131 of the first acquisition line 13a is connected to a temperature sensing member 16. The support 10 is also formed with a second accommodation recess 105 communicating with the first accommodation recess 103. The temperature sensing member 16 may include but is not limited to a thermistor and an infrared temperature sensor. The temperature sensing member 16 is disposed in the second accommodation recess 105 and is capable of acquiring a signal sent by the temperature sensing member 16 due to a temperature change in the nearby environment and transmitting the signal to the battery management circuit through the first acquisition line 13a, so that the battery management circuit can obtain the temperature changes of the environment in the first accommodation recess 103 and the second accommodation recess 105 near the temperature sensing member 16.

When the temperature sensing member 16 includes the thermistor, in one or more embodiments, the acquisition portions 131 of the two first acquisition lines 13a may be connected to the same temperature sensing member 16 so that the two first acquisition lines 13a can be connected to the temperature sensing member 16 to form a loop. In this manner, the two first acquisition lines 13a are configured to acquire the current changes at the two ends of the temperature sensing member 16 so that the battery management circuit 113 can calculate the resistance change of the temperature sensing member 16. Thus, the temperature change of the temperature sensing member 16 can be inferred, and the temperature changes of the environment in the first accommodation recess 103 and the second accommodation recess 105 near the temperature sensing member 16 are obtained.

In one or more embodiments, to enable the support 10 to accommodate multiple cells, the support 10 has multiple first accommodation recesses 103 arranged in the second direction S2. The second direction S2 is perpendicular to the first direction S 1. Thus, when each first accommodation recess 103 accommodates a cell, it is prone to forming a heat aggregation region in the middle of the support 10 in the second direction S2. In other words, it is prone to causing the support 10 to have the highest local temperature in the middle in the second direction S2. At this time, in one or more embodiments, at least one second accommodation recess 105 may be roughly located in the middle of the support 10 in the second direction S2, so that at least one temperature sensing member 16 is roughly located in the middle of the support 10 in the second direction S2. Further, the temperature sensing member 16 can cooperate with the first acquisition line 13a to roughly monitor the highest local temperature of the support 10.

Since the heat exchange efficiency between the position of the support 10 adjacent to the outside in the second direction S2 and the external environment is the highest, it is prone to causing the support 10 to have the lowest local temperature at this position. Based on this, further, a second accommodation recess 105 may be formed at the position of the support 10 adjacent to the outside in the second direction S2, so that the temperature sensing member 16 located in this second accommodation recess 105 can cooperate with the first acquisition line 13a to roughly monitor the lowest local temperature of the support 10.

Based on this, when the signal acquisition assembly 1 may be capable of acquiring the voltage signal of the cell, in one or more embodiments, the multiple signal acquisition lines 13 include a second acquisition line 13b. The second acquisition line 13b is electrically connected to the cell to acquire the electrical signal of the cell and further cooperates with two battery management circuits 113 electrically connected to the entire cells carried by the support 10 to enable the signal acquisition assembly 1 to acquire the voltage signal of the cell.

In one or more embodiments, when the signal acquisition assembly 1 also includes the electrical connection piece 15, the acquisition portion 131 of the second acquisition line 13b may be connected to and electrically conducted with the electrical connection piece 15. Thus, the acquisition portion 131 may be connected to the electrical connection piece 15 when the signal acquisition assembly 1 is assembled and does not need to be connected to the cell after the cell is disposed in the first accommodation recess 103. The acquisition portion 131 may be connected to the electrical connection piece 15 through methods including but not limited to welding and bolt connection and electrically conducted with the electrical connection piece 15.

It is to be understood that when the signal acquisition assembly 1 may be capable of acquiring the temperature signal and voltage signal of the cell, the multiple signal acquisition lines 13 may include both the first acquisition line 13a and the second acquisition line 13b described in the preceding technical solution.

As shown in FIG. 8, the present application also provides a battery pack 2. The battery pack includes a cell 20 and the signal acquisition assembly 1 described in the preceding technical solution. Referring to FIG. 1, the cell 20 is mounted on the first side surface 101. Since the signal acquisition line 13 of the signal acquisition assembly 1 has better connection stability with the circuit board 11, the battery pack 2 can still have good functional stability when vibration occurs.

In the description of the present application, it is to be understood that the orientation or position relationships indicated by terms "above", "below", "left", "right" and the like are based on the orientation or position relationships shown in the drawings, merely for facilitating description and simplifying operation, and these relationships do not indicate or imply that the referred device or element has a specific orientation and is constructed and operated in a specific orientation, and thus it is not to be construed as limiting the present application. In addition, the terms "first" and "second" are used only for distinguishing between descriptions and have no special meaning.

In the description of this specification, reference terms "an embodiment" and "example" are intended to be included in at least one of embodiments or examples of the present application in connection with specific characteristics, structures, materials or features described in this embodiment or example. In the specification, the illustrative description of the preceding terms does not necessarily refer to the same embodiment or example.

Moreover, it is to be understood that although this specification is described in terms of the embodiments, not each embodiment includes only one independent technical solution. Such description mode of the specification is merely for the sake of clarity, and those skilled in the art should regard the specification as a whole. The technical solutions in the embodiments may also be appropriately combined to form other embodiments which can be understood by those skilled in the art.

## Claims

1. A signal acquisition assembly (1) of a cell (20), comprising:
a support (10) comprising a first side surface (101) and a second side surface (102) opposite to each other in a first direction, wherein the first side surface (101) is configured to mount the cell (20);
a circuit board (11) connected to the support (10) and located on the second side surface (102), wherein the circuit board (11) is provided with a plurality of plug-in structures (110), the circuit board (11) carries a battery management circuit (113), and the battery management circuit (113) is configured to be electrically connected to the cell (20);
a plurality of pin-type electrical connectors (12), wherein each of the plurality of pin-type electrical connectors (12) comprises a first connection portion (1210) and a pin-type plug-in portion (1220), pin-type plug-in portions (1220) of the plurality of pin-type electrical connectors (12) are plugged in the plurality of plug-in structures (110) in one-to-one correspondence, and the pin-type plug-in portions (1220) are electrically connected to the battery management circuit (113); and
a plurality of signal acquisition lines (13), wherein each of the plurality of signal acquisition lines (13) comprises a second connection portion (130) and an acquisition portion (131), second connection portions (130) of the plurality of signal acquisition lines (13) are correspondingly connected to first connection portions (1210) of the plurality of pin-type electrical connectors (12), and the acquisition portion (131) is configured to acquire a signal of the cell (20).

2. The signal acquisition assembly according to claim 1, wherein the support (10) further comprises a limit structure (104) protruding from the second side surface (102), the plurality of pin-type electrical connectors (12) are partially disposed in the limit structure (104), and for each of the plurality of pin-type electrical connectors (12), at least part of the first connection portion (1210) and the pin-type plug-in portion (1220) are exposed to an external environment of the support (10).

3. The signal acquisition assembly according to claim 2, wherein a side of the circuit board (11) facing the second side surface (102) carries a plurality of electronic components (111), and in the first direction, projections of the plurality of electronic components (111) and a projection of the limit structure (104) on the circuit board (11) do not overlap; and
in the first direction, a height of the limit structure (104) protruding from the second side surface (102) is h1, and a maximum height of the plurality of electronic components (111) protruding from the circuit board (11) in the first direction toward the support (10) is h2, and h1 ≥ h2.

4. The signal acquisition assembly according to claim 1, wherein each of the plurality of pin-type electrical connectors (12) comprises a first portion (121) and a second portion (122) connected at an included angle, the first portion (121) has the first connection portion (1210) and is disposed in the support (10), and the second portion (122) has the pin-type plug-in portion (1220).

5. The signal acquisition assembly according to claim 4, wherein the second side surface (102) is provided with a plurality of first limit grooves (1041) arranged at intervals, a first limit groove of the plurality of first limit grooves (1041) has a first opening facing the circuit board (11), the first portion (121) is at least partially disposed in a respective first limit groove (1041) of the plurality of first limit grooves (1041), and at least part of a side of the first connection portion (1210) away from a bottom of the respective first limit groove (1041) is exposed to an external environment of the support (10) through the first opening.

6. The signal acquisition assembly according to claim 4, wherein the second portion (122) comprises a main body portion (1221) connected between the first portion (121) and the pin-type plug-in portion (1220), the support (10) further comprises a second limit portion (1042) disposed on the second side surface (102), the second limit portion (1042) is provided with a plurality of second limit grooves (1042a) arranged at intervals, a second limit groove (1042a) of the plurality of second limit grooves (1042a) has a second opening located on a side of the second limit portion (1042) adjacent to the circuit board (11), the main body portion (1221) is disposed in a respective second limit groove (1042a) of the plurality of second limit grooves (1042a), and at least part of the pin-type plug-in portion (1220) extends from the second opening toward the circuit board (11).

7. The signal acquisition assembly according to any one of claims 1 to 6, wherein the plurality of pin-type electrical connectors (12) are embedded in the support (10).

8. The signal acquisition assembly according to any one of claims 1 to 6, wherein the first connection portion (1210) is located between the support (10) and the circuit board (11).

9. The signal acquisition assembly according to any one of claims 1 to 6, wherein the pin-type plug-in portion (1220) is further welded to the circuit board (11) and electrically connected to the battery management circuit (113), or a plug-in structure of the plurality of plug-in structures (110) further comprises an elastic conductive member, and the elastic conductive member is electrically connected to the battery management circuit (113) and configured to elastically abut against the pin-type plug-in portion (1220).

10. The signal acquisition assembly according to any one of claims 1 to 6, wherein the plurality of signal acquisition lines (13) comprise a first acquisition line (13a), and the acquisition portion (131) of the first acquisition line (13a) is connected to a temperature sensing member (16); and
the support (10) is provided with a first accommodation recess (103) formed in the first side surface (101), the first accommodation recess (103) is configured to accommodate the cell (20), the support (10) is further provided with a second accommodation recess (105) communicating with the first accommodation recess (103), and the temperature sensing member (16) is disposed in the second accommodation recess (105).

11. The signal acquisition assembly according to any one of claims 1 to 6, wherein the support (10) is provided with a plurality of first accommodation recesses (103) formed in the first side surface (101), the first accommodation recesses (103) are configured to accommodate the cell (20) and arranged in a second direction, and each of the plurality of first accommodation recesses (103) is configured to accommodate one cell (20);
the signal acquisition assembly further comprises an electrical connection piece (15) disposed on the support (10), the electrical connection piece (15) corresponds to a side of two adjacent first accommodation recesses of the plurality of first accommodation recesses (103) in a third direction, and the electrical connection piece (15) is configured to electrically connect two cells (20) respectively located in the two adjacent first accommodation recesses (103), wherein the first direction, the second direction, and the third direction intersect each other in pairs; and
the plurality of signal acquisition lines (13) comprise a second acquisition line (13b), and the acquisition portion (131) of the second acquisition line (13b) is connected to and electrically conducted with the electrical connection piece (15).

12. The signal acquisition assembly according to claim 11, wherein the electrical connection piece (15) is provided with an engaging hole (150) and the support (10) is provided with a protrusion (106) corresponding to the engaging hole (150), or the support (10) is provided with an engaging hole (150) and the electrical connection piece (15) is provided with a protrusion (106) corresponding to the engaging hole (150); and the protrusion (106) is configured to pass through the engaging hole (150) to enable the electrical connection piece (15) to be engaged with the support (10).

13. The signal acquisition assembly according to any one of claims 1 to 6, wherein the signal acquisition assembly (1) further comprises a busbar (14), the busbar (14) has a first end (141) and a second end (142) opposite to each other, the first end (141) is configured to be electrically connected to the cell (20), the second end (142) is electrically connected to the battery management circuit (113), the support (10) is formed with a first threaded hole, the circuit board (11) is formed with a first through hole corresponding to the first threaded hole, the second end (142) is formed with a second through hole corresponding to the first through hole, and a first bolt passes through the second through hole and the first through hole in sequence and is screwed into the first threaded hole to connect the second end (142) and the circuit board (11) to the support (10).

14. The signal acquisition assembly according to claim 13, wherein the busbar (14) further comprises an arched bending structure (143) connected between the first end (141) and the second end (142), and the arched bending structure (143) is configured to be elastically deformed.

15. A battery pack, comprising a cell (20) and the signal acquisition assembly according to any one of claims 1 to 14, wherein the cell (20) is mounted on the first side surface (101) of the signal acquisition assembly (1).
